Europäisches Patentamt

European Patent Office

Office européen des brevets

(11) Publication number: **0 365 687 B1**

## EUROPEAN PATENT SPECIFICATION

(45) Date of publication of patent specification: **29.06.94**  (51) Int. Cl.⁵: **C23C 14/06**, C23C 14/32

(21) Application number: **89905196.5**

(22) Date of filing: **25.04.89**

(86) International application number:
**PCT/JP89/00435**

(87) International publication number:
**WO 89/10426 (02.11.89 89/26)**

(54) **STEEL SHEET HAVING DENSE CERAMIC COATING WITH EXCELLENT ADHESION,SMOOTHNESS AND CORROSION RESISTANCE AND PROCESS FOR ITS PRODUCTION.**

(30) Priority: **25.04.88 JP 100183/88**
**23.06.88 JP 153645/88**
**18.08.88 JP 203924/88**

(43) Date of publication of application:
**02.05.90 Bulletin 90/18**

(45) Publication of the grant of the patent:
**29.06.94 Bulletin 94/26**

(84) Designated Contracting States:
**DE FR GB IT SE**

(56) References cited:
**EP-A- 0 186 266**
**DE-A- 3 724 626**
**JP-A- 5 896 869**
**JP-A-52 149 275**
**JP-A-62 151 555**

(73) Proprietor: **KAWASAKI STEEL CORPORATION**
**No. 1-28, 1-chome**
**Kitahonmachi-dori**
**Fukiai-ku Kobe-shi Hyogo 651(JP)**

(72) Inventor: **INOKUCHI, Y. Kawasaki Steel Corp.**
**Techn. Res. Div.**
**1, Kawasaki-cho;**
**Chiba-shi Chiba 260(JP)**
Inventor: **KOBAYASHI, Y. Kawasaki Steel**
**Corp. Tech. Res. Div.**
**1, Kawasaki-cho**
**Chiba-shi Chiba 260(JP)**
Inventor: **SUZUKI, K. Kawasaki Steel Corp.**
**Tech. Res. Div.**
**1, Kawasaki-cho**
**Chiba-shi Chiba 260(JP)**
Inventor: **ITO, Y. Kawasaki Steel Corp. Tokyo**
**Head Office**
**2-3, Uchisaiwai-cho 2-chome**
**Chiyoda-ku**
**Tokyo 100(JP)**

JOURNAL OF VACUUM SCIENCE & TECH-NOLOGY A, vol. 4, no. 2, March-April 1986, pp. 210-214, American Vacuum Society, Woodbury, New York, US; K. KASHIWAGI et al.: "Chromium nitride films synthesized by radio-frequency reactive ion plating"

(74) Representative: **Overbury, Richard Douglas et al**
**HASELTINE LAKE & CO**
**Hazlitt House**
**28 Southampton Buildings**
**Chancery Lane**
**London WC2A 1AT (GB)**

**Description**

TECHNICAL FIELD

This invention relates to a method of forming a ceramic coating having rich adhesion property, smoothness and corrosion resistance onto a surface of a low carbon steel sheet, a stainless steel sheet or the like.

BACKGROUND ART

Recently, the coating technique using plasma has considerably advanced and is widely used in various fields. The use of such a coating technique includes, for example, the formation of magnetic recording thin films, various abrasion resistant coatings, corrosion resistant coatings, decorative coatings, far-infrared ray heating elements and the like.

In general, the vapour of a metal, semi-metal or the like can be ionized or activated to give high kinetic energy by utilizing the plasma, whereby sheets having good adhesion properties between vapour deposited film and substrate and film quality are obtained.

The magnetro sputtering method, EB (electron beam) + RF (radio frequency) method, plasma CVD method and the like have previously been employed as the plasma coating method, and the multi arc method using a vacuum arc, and ion plating using hollow cathode discharge (HCD) method are recently known.

Among these plasma coating methods, the hollow cathode discharge method is relatively high in the ionization ratio and the film forming rate, so that it is utilized for small size ceramic coatings such as decorative articles, tools and the like.

In order to form a ceramic coating having improved properties such as adhesion properties, uniformity, corrosion resistance and the like onto a surface of steel sheet having a large surface area by these methods, it is necessary to increase the ionization ratio in the ion plating or ion implantation treatment, to increase the voltage applied to the steel sheet and to raise the temperature of the steel sheet.

In the coating film obtained by such a treatment, the film quality, adhesion properties and corrosion resistance are largely improved, but neither satisfactory adhesion properties nor a satisfactory corrosion resistance is obtained, and hence an improvement in these properties is sought.

Particularly, ion plating treatment by the hollow cathode discharge method can improve the corrosion resistance, decorative property or wear resistance of steel sheets having a large surface area for use in building materials or the like, so that the utilization thereof is attempted, but it has not yet been put into practical use.

Such a steel sheet is required to have the following conditions:
1) good adhesion properties between the steel sheet and the ceramic coating;
2) uniform coating of the ceramic over a large surface area;
3) good film quality(particularly densification) for the ceramic coating;
4) excellent corrosion resistance;
5) formation of the coating on a steel sheet having a large surface area at a high speed and under good plasma atmosphere; and the like,
but the above conditions cannot be sufficiently satisfied by the conventional hollow cathode discharge method.

Apart from this, recent investigations on the properties of surface-treated steel sheets which have been treated by ion plating using the arc discharge method, report that when a different metal is subjected to dry plating at an interface of a steel sheet to form a double layer coating, the corrosion resistance is considerably improved when compared with that of a single layer coating. {see Tetsu to Hagane, 72(1986), S1309 by Hiroshi Kagechika, Hiroshi Kibe, Takeshi Aniya, Hiroshi Naemura, Takashi Haratomi}. On the other hand, JP-A-62-99458 discloses a method consisting of a first step of conducting ion plating under a high vacuum atmosphere of not higher than $1.0 \times 10^{-5}$ Torr ($1.3 \times 10^{-3}$Pa) to form a first plated layer, and a step of forming a plated layer of a different material from the first layer on top of the above layer. This ion plating method requires the use of a high vacuum of not higher than $1.0 \times 10^{-5}$ Torr ($1.3 \times 10^{-3}$Pa), so that there will be a problem when it is actually adopted on an industrial scale.

Furthermore, it has lately been reported that the corrosion resistance is improved by subjecting stainless steel sheet after the electrolysis with nitric acid to a $SiO_2$ or $Si_3N_4$ coating through plasma CVD (Hashimoto et al: CAMP - ISIJ. Vol. 1 (1988), P426 and Japanese Patent laid open No. 63-62860). In this method, however, the ion bombardment treatment is usually conducted before the dry plating treatment, so that the electrolytic effect on the surface of the steel sheet is removed to form a passive film on the surface of the stainless steel sheet, and consequently the adhesion properties between steel sheet and ceramic coating are deteriorated and many problems remain to be solved when it is adopted in the actual production step.

In Japanese Patent Application Publication No. 55-33595, it has been attempted to adhere a substance having a good far-infrared ray radioactivity, such as $TiO_2$, $ZrO_2$, $Al_2O_3$ or the like, onto a surface of metal sheath type heating element suitable for use as a far-infrared ray heating element in a heat source for heating or drying, a reflective plate for a stove and the like. In this method, however, the difference in thermal expansion coefficients between the heating element and the ceramic coating is large, so that the ceramic surface layer is apt to be peeled off.

As a means for solving this problem, a method is proposed in which a ceramic heating element consisting mainly of conductive ceramic (such as TiC, TiN, $TiC$-$TiN$-$Al_2O_3$ or the like) is used instead of the metal sheath type heating element, and the aforementioned far-infrared ray reflection type ceramic layer (such as $TiO_2$ or the like) is formed on the surface thereof as disclosed in JP-A-60-60990 and 60-130082. In this case, however, the coating method is via spraying, immersion or heat treatment, so that it can not be said to be a basic countermeasure.

DISCLOSURE OF INVENTION

The invention advantageously solves the above problems and provides a method of forming a dense ceramic coating, having excellent adhesion properties, smoothness and corrosion resistance, when the ceramic coating is formed on low carbon steel sheet, stainless steel sheet or the like.

The inventors have investigated the above problems, and as a result it has been found out that a focusing coil for guiding vapour onto a substrate (which has hitherto been arranged only in the vicinity of a vapour source), extended near to the substrate so that the inside of such an elongated focusing coil may be used as a passage for guiding the vapour, enables ion plating to be carried out under conditions in which the power applied to HCD beam and the focusing coil satisfy a given range, resulting in a very dense ceramic coating being obtained. Hence the adhesion properties, smoothness and corrosion resistance are considerably improved.

The invention is based on the above knowledge.

That is, the invention lies in a steel sheet with a dense ceramic coating having improved adhesion properties, smoothness and corrosion resistance, comprising an undercoat formed on a surface of a low carbon steel sheet or a stainless steel sheet and made from at least one metal and/or semimetal, and at least one layer of a ceramic coating formed on said undercoat; said ceramic coating having a surface roughness (Ra) of not more than 0.4 $\mu$m and a pore number per 1 $cm^2$ of not more than 1.

Furthermore, the invention lies in a method of producing steel sheets with a dense ceramic coating having improved adhesion properties, smoothness and corrosion resistance by forming a ceramic coating onto a surface of low carbon steel sheet or stainless steel sheet through an ion plating treatment using the HCD method, which comprises forming a metal and/or semimetal coating made from at least one metal and/or semimetal as a first layer onto said surface of said steel sheet and forming a ceramic coating as a second layer on said coating, using the inside of a focusing coil as the passage for evaporated vapour, wherein the focusing coil surrounds the outer periphery of a crucible containing the substance to be vapourised and extends near to said surface of said steel sheet, and wherein the power of the HCD beam satisfies the relationship :

$$30 \leq H \leq 160$$

and the power of the focusing coil satisfies the relationship :

$$0.2 + 0.03H \leq F \leq 5.5 + 0.075H$$

(where
H is the power (kW) of the HCD beam, and
F is the power (kW) of the focusing coil)

In the invention, it is advantageous that prior to the formation of the metal and/or semimetal coating as a first layer, the steel sheet surface is subjected to a polishing treatment so the surface roughness has a value Ra$\leq$0.4 $\mu$m, or the steel sheet is preliminarily heated at 100-600°C, or further the steel sheet surface is subjected to Cr or Ni plating through a wet plating.

Furthermore, in the invention, a ceramic coating can repeatedly be formed on the ceramic coating as a second layer irrespective of the presence or absence of the metal and/or semimetal coating, if necessary.

Moreover, in the invention, it is advantageous that an annealing treatment is carried out at 500-1200°C in an oxidizing atmosphere after the formation of the ceramic coating as a final layer.

According to the invention, at least one layer selected from; nitrides, carbides and carbonitrides of Ti, Zr, Hf, V, Nb, Ta, Cr, Mo, W, Mn, Co, Ni, Al, B and Si, and oxides of Al, Zn, Mn, Mg, Ti, Cr, B, Ni and Si is particularly advantageous as ceramic coating.

Thus, when the ion plating is carried out according to the invention, steel sheets provided with a very dense ceramic coating, not only having excellent adhesion properties and corrosion resistance but also with an excellent smoothness of Ra≦0.4 $\mu$m and pore number per 1 cm$^2$ of ≦1 are obtained.

The invention will be described in detail below.

At first, the invention is described with respect to experimental results succeeding the invention.

A hot rolled sheet (thickness 2.2 mm, width 500 mm) of low carbon steel containing C: 0.044 wt% (hereinafter shown by %), Mn: 0.30%, P: 0.008% and S: 0.012% was cold rolled to a thickness of 0.3 mm, and then subjected to recrystallization annealing at 750°C, and thereafter the steel sheet surface was degreased and a TiN coating was formed on the steel sheet surface by the following methods; ①, ②, ③, ④, ⑤ and ⑥.

Account

① The coating formation was carried out by a so-called EB + RF method wherein Ti was evaporated by electron beam scanning and ionized with an RF (Radio Frequency) coil to form TiN coating (1.0 $\mu$m thickness). The treatment was under a vacuum of 6x10$^{-4}$ Torr (8x10$^{-2}$Pa), and the EB (pierce type) irradiating conditions were an acceleration voltage: 60 kV, current: 5 mA and RF power of 800 W. Furthermore, the preliminary heating temperature was 400°C and the applied voltage was 800 V.

② The coating formation was carried out by EB + RF method wherein a Ti coating (0.5 $\mu$m thickness) was formed on the steel sheet surface by electron beam scanning and Ti was evaporated and ionized by RF coil to form a TiN ceramic coating (0.5 $\mu$m thickness). The conditions for coating Ti as a first layer included a vacuum of 2x10$^{-4}$ Torr (2.6x10$^{-2}$Pa), and the EB (pierce type) irradiating conditions were acceleration voltage: 60 kV and current: 5 mA. For the formation of TiN coating as a second layer, the power of RF for ionization of N$_2$ gas was 800 W under the same EB conditions. The vacuum used in the formation of TiN coating was 7x10$^{-4}$ Torr (9.3x10$^{-2}$Pa), and the preliminary heating and applied voltage were the same as in the conditions of ①.

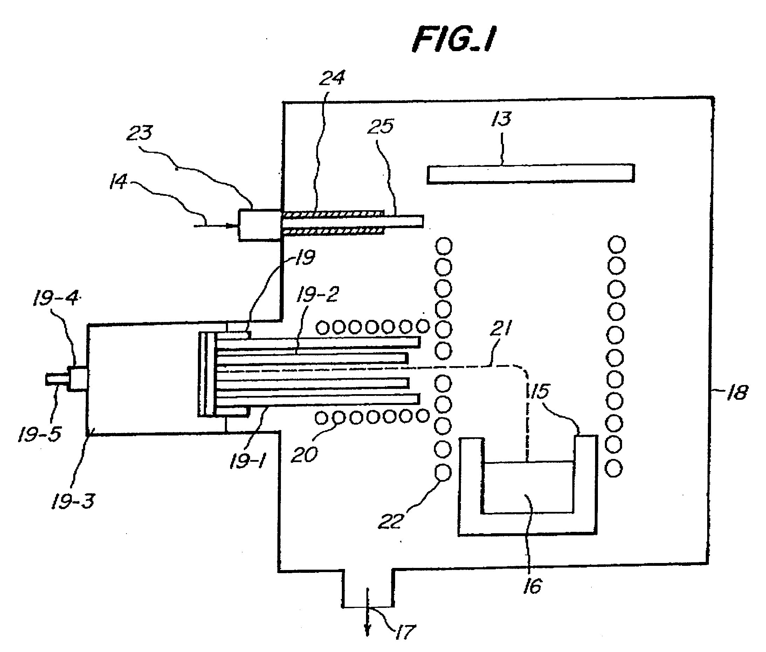

③ A TiN coating of 1 $\mu$m in thickness was formed on the steel sheet surface using an ion plating apparatus of HCD system shown in Fig. 1.

In this drawing, 13 is a substrate, 14 an inlet of reaction gas, 15 a crucible, 16 an evaporation source (Ti), 17 a discharge port for high vacuum suction, 18 a vacuum tank, and 19 an HCD gun.

The HCD gun is a combination of an outer layer 19-1 made from graphite and an inner layer 19-2 (made from Ta in this embodiment), wherein the outer and inner layers are separated from each other by a certain distance. Furthermore, in order to prevent discharge between layers, current can flow from inner layer 19-2 to the evaporation source inside crucible 15 though the illustration is omitted. Thus, abnormal discharge of the HCD gun is reduced and the HCD gun enjoys a long life.

Furthermore, HCD gun 19 is always held at a constant distance from to crucible 15 by means of a feed mechanism 19-3, whereby the supply of a stable plasma beam can be ensured over a long period of time. 19-4 is a power source for the HCD gun and 19-5 is an inlet for Ar gas.

20 is a focusing coil arranged around HCD gun 19. The generated plasma is focused into a fine plasma beam 21 by focusing coil 20. Then, focused fine plasma beam 21 is deflected so as to bend in a direction perpendicular to the surface of the evaporation source, as shown by dotted lines in the drawing, by means of a focusing coil 22 arranged around the crucible 15. Focusing coil 22 changes the direction of the magnetic field and irradiates the evaporation source. Irradiation with the perpendicularly bent plasma beam evaporates the top of the evaporation source, whereby the uniform deposition of evaporated vapour on to the substrate can be achieved.

In this case, focusing coil 22 extends close to the inlet passage of reaction gas and up to the vicinity of the substrate, ensuring a very good plasma state is maintained inside the passage, so that the substance to be evaporated is vapourised and ionized by the HCD beam goes straight on to substrate 13 and hence the deposition efficiency is considerably enhanced. 23 is a voltage applied device for reaction gas, which is provided with a cooling tube 24 and an inlet tube 25 made from Ta. The ionization of the reaction gas can be promoted by applying a voltage to inlet tube 25.

The ion plating conditions in the HCD method using the apparatus of the drawing were acceleration voltage of 75 V, current of 1000 A and a vacuum of $7.5\times10^{-4}$ Torr ($1\times10^{-1}$Pa). In addition, the preliminary heating temperature was 400°C and the applied voltage was 60 V.

④ After a Ti coating of 0.5 μm in thickness was deposited onto the steel sheet surface with the ion plating apparatus shown in Fig. 1, a TiN ceramic coating (0.5 μm thickness) was further formed thereon. The coating formation conditions were the same as in the above item ③.

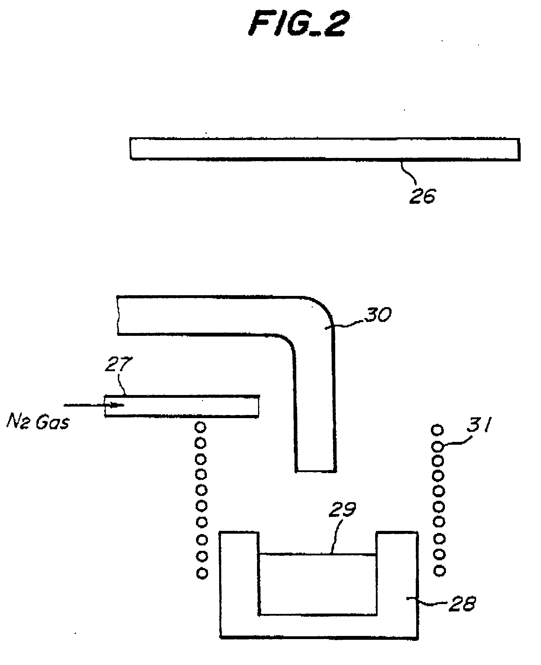

⑤ A TiN coating of 1 μm was formed by an ion plating treatment using the conventional HCD method and an ion plating apparatus as shown in Fig. 2. In this case, the treating conditions were acceleration voltage of 70 V, current of 1000 A and a vacuum of $7\times10^{-4}$ Torr ($9.3\times10^{-2}$Pa). The preliminary heating temperature was 400°C and the applied voltage was 60 V.

In this drawing, 26 is a substrate, 27 a tube for reaction gas, 28 a crucible, 29 an evaporation source (Ti), 30 a usual L-shaped HCD gun, and 31 a focusing coil.

⑥ After a Ti coating of 0.5 μm in thickness was formed using the ion plating apparatus shown in Fig. 2, a TiN coating of 0.5 μm in thickness was formed thereon. The treating conditions were the same as in method ⑤.

The uniformity, corrosion resistance, adhesion properties, smoothness and densifying degree (porosity) of the coatings obtained by the above treatments were measured and the results are shown in Table 1.

As seen from the above table, when the Ti coating is formed according to the method of the invention in ④, and a further TiN coating is formed thereon, the evaporation rate, uniformity of coating, corrosion resistance, adhesion properties, smoothness and densifying degree are all excellent when compared with methods ①, ②, ③, ⑤ and ⑥. Particularly, it is noticed that the corrosion resistance and adhesion properties are excellent in the case when the TiN coating is formed on the Ti layer, as compared with the

Table 1

| Condition | Ion plating method | Evaporation rate (μm/min) | *1 Uniformity | *2 Corrosion resistance | *3 Adhesion property | *4 Smoothness | *5 Porosity |
|---|---|---|---|---|---|---|---|
| ① | Formation of TiN (1 μm thickness) by EB+RF | 0.6 | ±35 | × | × | × | × |
| ② | Formation of TiN (0.5 μm thickness) by EB+RF after the formation of Ti (0.5μm thickness) by EB | 0.6~0.7 | ±35 | △ | × | × | × |
| ③ | Formation of TiN (1 μm thickness) by a method of Fig. 1 | 2.5 | ±20 | △ | △ | ○ | ○ |
| ④ | Formation of TiN (0.5 μm thickness) after the formation of Ti (0.5 μm thickness) by a method of Fig. 1 | 2.5~2.7 | ±20 | ○ | ○ | ○ | ○ |
| ⑤ | Formation of TiN (1 μm thickness) by a method of Fig. 2 | 1.0 | ±30 | △ | △ | × | △ |
| ⑥ | Formation of TiN (0.5 μm thickness) after the formation of Ti (0.5 μm thickness) by a method of Fig. 2 | 1.0~1.2 | ±30 | △ | △ | △ | △ |

*1: The difference in thickness between central portion and end portion is represented by %.

*2: spraying test with saline solution: 3.5% saline solution, 35°C, spraying for 4 hours·drying for 1 hour × 3 cycles
×: corrosion  △: somewhat corrosion  ○: no corrosion

*3: 360° bending after high temperature annealing
×: full peeling, △: somewhat peeling, ○: no peeling

*4: observation with scanning microscope
×: Ra>0.4 μm, ○: Ra≦0.4 μm

*5: Ferroxyl test (number of pores per 1 cm$^2$)
×: many (10 or more)  △: small (9-2)  ○: very few (1 or less)

7

case ③ in which TiN is directly formed on the steel sheet surface.

As to the invention method ④, the formation state of the ceramic coating was further investigated in detail by using an electron microscope. Consequently, it has been found that the state of the coating formed largely depends on the conditions of forming the high plasma atmosphere or the difference in power of the focusing coil located on the passage of moving evaporated substance.

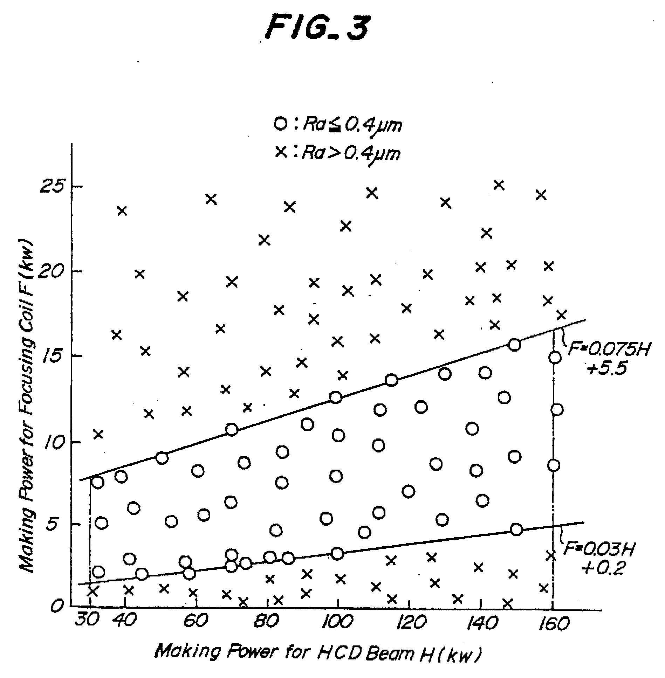

Fig. 3 shows the measured relationship between the power of the focusing coil and the power of an HCD beam required to obtain a smooth ceramic coating.

As seen from this drawing, in order to obtain a smooth ceramic coating, the powers of the focusing coil and the HCD beam exist within defined ranges, respectively, and it is necessary to adjust the power of the focusing coil in accordance with the power of the HCD beam. That is, it has been found that the following conditions should be satisfied:

$$30 \leq H \leq 160$$
$$0.2 + 0.03H \leq F \leq 5.5 + 0.075H$$

, where

H: power of the HCD beam (kW)
F: power of the focusing coil (kW).
The reason is considered to be as follows:

A good ceramic coating is only obtained by making an optimum plasma atmosphere. If the power of the focusing coil is too small, a high plasma atmosphere cannot be generated, so that the coating becomes uneven and rough; while if the power of the focusing coil is too large, the magnetic field becomes extremely strong at the central portion only thereby not producing a favorable plasma atmosphere. In any case, a smooth ceramic coating cannot be obtained. Therefore, in order to obtain a smooth ceramic coating, it is important to satisfy the above ranges. Moreover, the reason why power H of the HCD beam in the above equation is limited to the above range is that when the power of the HCD beam is less than 30 kW, the ionization energy available to the evaporated vapour is insufficient and a good plasma atmosphere cannot be formed; while when it exceeds 160 kW, the beam is scattered by the evaporated vapour and the evaporation energy is degraded.

As to the improvement in the adhesion properties, corrosion resistance and smoothness, it has been found that the corrosion resistance, adhesion properties and smoothness can be largely improved by forming a metal and/or semimetal coating onto the steel sheet surface as a first layer, and a ceramic coating as a second layer, under particular treating conditions in the same way that when different metals are dry plated to form two-layer coatings under a super vacuum of not more than $1 \times 10^{-5}$ Torr ($1.3 \times 10^{-3}$Pa), which is impossible for practical purposes on an industrial scale on the surface-treated steel sheet. The considerable improvement in corrosion resistance is noticeable when compared with that of a single layer coating as mentioned above. Therefore, the invention is very useful in the production of practically useful ceramic coated steel sheets.

In this connection, it has hitherto been known to form ceramic coating of TiN, CrN or the like as 1-2 layer by using the spraying method. However, the number of pores in the ceramic coating formed by the spraying method is large when compared with the coating formed under vacuum, the smoothness is also very poor, so that a coating having a rich smoothness with an Ra value of not more than 0.4 $\mu$m as a center-line average roughness cannot be obtained at all.

According to the invention, in order to improve the adhesion properties between the steel sheet and the ceramic coating, in addition to the improvement the of corrosion resistance through the formation of a metal-ceramic coating, it is desirable that the preliminary heating temperature is raised to 100-600°C and the applied voltage is within the range of 10-200 V.

A hot rolled sheet of stainless steel containing C: 0.015%, Mn: 0.35%, Cr: 18.8% and Si: 0.13% (2.3 mm thickness) was subjected to a cold rolling - heat treatment to a thickness of 0.25 mm, and (A) Cr of 2.0 $\mu$m in thickness, or (B) Cr of 1.0 $\mu$m in thickness was formed onto the steel sheet surface by wet plating. In case (B), the Cr coating was further subjected to dry plating according to (a) - (d).

(a) TiN was formed at a thickness of 1.0 $\mu$m by EB + RF;
(b) TiN was formed at a thickness of 1.0 $\mu$m by the method of Fig. 1;
(c) Ti (0.5 $\mu$m thickness) was formed by the method of Fig. 1 and TiN (0.5 $\mu$m thickness) was formed thereon;
(d) Ti (0.5 $\mu$m thickness) was formed by the method of Fig. 2 and TiN (0.5 $\mu$m thickness) was formed thereon.

8

The evaporation rate, uniformity, corrosion resistance, adhesion properties, smoothness and densifying degree of the thus obtained ceramic coatings were measured to and the results are shown in Table 2.

Table 2

| Wet plating | Ion plating treatment | Evaporation rate (μm/min) | Uni-formity *1 | Corrosion resistance *2 | Adhesion property *3 | Smoothness *4 | Porosity *5 |
|---|---|---|---|---|---|---|---|
| (A) Cr plating at a thickness of 2.0 μm | none | - | - | × | × | × | × |
| (B) Cr plating at a thickness of 1.0 μm | (a) | 0.6 | ±35 | × | × | × | × |
| | (b) | 2.6 | ±20 | △ | ○ | ○ | ○ |
| | (c) | 2.8 | ±20 | ○ | ○ | ○ | ○ |
| | (d) | 1.0 | ±30 | △ | ○ | △ | △ |

*1: The difference in thickness between central portion and end portion is represented by %.

*2: spraying test with saline solution: 3.5% saline solution, 35°C, spraying for 4 hours·drying for 1 hour × 6 cycles
×: fairly corrosion, △: somewhat corrosion, ○: no corrosion

*3: 360° bending after high temperature annealing
×: full peeling, △: somewhat peeling, ○: no peeling

*4: observation with scanning microscope
×: Ra>0.4 μm, ○: Ra≦0.4 μm

*5: Ferroxyl test (number of pores per 1 cm$^2$)
×: many (10 or more) △: small (9-2) ○: very few (1 or less)

As seen from Table 2, when the Cr coating is formed by wet plating and the TiN coating is formed thereon according to method (c) of the invention, the evaporation rate, coating uniformity, corrosion resistance, adhesion properties, smoothness and densifying degree are all excellent when compared with those of methods (a), (b) and (d), as well as in the case of no ion plating.

Next, a hot rolled sheet of stainless steel containing C: 0.015%, Mn: 0.15%, Cr: 18.5% and Ni: 8.6% (2.3 mm thickness) was subjected to cold rolling - recrystallization annealing to form a sheet of 0.25 mm in thickness, and thereafter the surface was degreased. Then, the steel sheet surface was subjected to coating treatments (a) - (c) using; ① HCD method, ② (EB + RF) method and ③ spraying method, whereby TiC or $TiO_2$ coating was formed as an outermost layer.

(a) Cr of 0.5 $\mu$m was formed and TiC of 1.5 $\mu$m was formed thereon;

(b) Cr of 0.5 $\mu$m was formed, and TiC of 0.5 $\mu$m was formed, and then $TiO_2$ of 1.0 $\mu$m was formed;

(c) Cr of 0.5 $\mu$m was formed, and TiC of 1.5 $\mu$m was formed, and annealing was then carried out at 800°C in an oxidizing atmosphere.

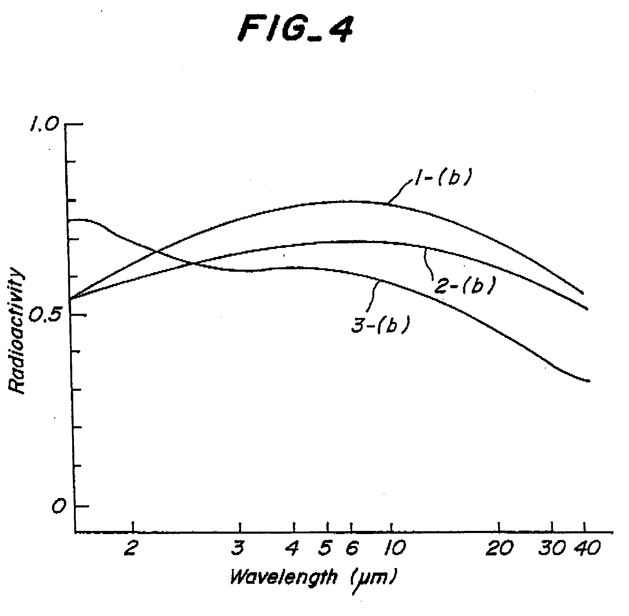

The wavelength dependency of radioactivity at 600°C (surface temperature of sample) was measured and the results are shown in Fig. 4, while the adhesion properties, peeling properties at rapid heating and rapid cooling and radioactivity at a wavelength of 7 $\mu$m were measured and the results are shown in Table 3.

Table 3

| | Method | Coating method | *1 Adhesion property | *2 Peeling property | *3 Radiation property |
|---|---|---|---|---|---|
| ① | HCD method (Invention) | (a) Cr of 0.5 µm was formed and TiC of 1.5 µm was formed thereon | ○ | ○ | 0.7 |
| | | (b) Cr of 0.5 µm was formed, and TiC of 0.5 µm was formed, and further TiO$_2$ of 1.0 µm was formed | ○ | ○ | 0.8 |
| | | (c) Cr of 0.5 µm was formed, and TiC of 1.5 µm was formed, and the annealing was further carried out at 800°C in an oxidizing atmosphere | ○ | ○ | 0.8 |
| ② | (EB+RF) method | (a) Cr of 0.5 µm was formed and TiC of 1.5 µm was formed thereon | △ | △ | 0.6 |
| | | (b) Cr of 0.5 µm was formed, and TiC of 0.5 µm was formed, and further TiO$_2$ of 1.0 µm was formed | △ | × | 0.6 |
| | | (c) Cr of 0.5 µm was formed, and TiC of 1.5 µm was formed, and the annealing was further carried out at 800°C in an oxidizing atmosphere | △ | △ | 0.6 |
| ③ | Spraying method | (a) Cr of 0.5 µm was formed and TiC of 1.5 µm was formed thereon | × | × | 0.6 |
| | | (b) Cr of 0.5 µm was formed, and TiC of 0.5 µm was formed, and further TiO$_2$ of 1.0 µm was formed | × | △ | 0.6 |
| | | (c) Cr of 0.5 µm was formed, and TiC of 1.5 µm was formed, and the annealing was further carried out at 800°C in an oxidizing atmosphere | × | △ | 0.7 |

*1: 90° bending properties (repeat 4 times)
○: no peeling  △: somewhat peeling  ×: peeling
*2: Peeling properties through rapid heating and rapid cooling treatments
○: no peeling  △: somewhat peeling  ×: peeling
*3: radioactivity at sample temperature (600°C) and wavelength of 7 µm

As seen from Table 3 and Fig. 4, in the case ① formed through the HCD method, the adhesion properties, peeling properties and radiation property are good under all the conditions (a) - (c) as compared with the cases formed using methods ② and ③.

Moreover, in case ①, the radiation property is better under conditions (b) and (c) than under condition (a).

11

As mentioned above, when the coating is formed using the HCD method, the ionization ratio is as high as 40-60% as compared with the other (EB + RF) method or the spraying method, so that the quality of the coating can be densified, from which it is considered that materials having improved uniformity, adhesion properties, smoothness and radiation property may be obtained.

It is preferable that the starting material used in far-infrared radiating material according to the invention is low carbon steel sheet and stainless steel sheet, particularly relatively thin steel sheets (0.1-1.5 mm thickness) capable of being mass produced and shaped, which are inexpensive and are electrically conducting.

These steel sheets are usually produced by hot rolling, cold rolling and annealing treatment steps and then greased or further rendered into a mirror state of Ra≦0.4 μm by a polishing treatment. Thereafter, the surface of each of these steel sheets is subjected to a coating using the HCD method. In this case, according to the invention, it is required to coat at least one metals and/or semimetals, such as Ti, Cr, Al, Ni, Si, B and the like, at a thickness of about 0.1-5 μm in order to provide a good adhesion properties to the steel sheet. Next, a ceramic coating of about 0.1-3 μm in thickness is formed on the metal and/or semimetal coating through the HCD method.

In this case, it is more advantageous to preliminarily heat the steel sheet at 100-600°C prior to the formation of the above first layer of metal and/or semimetal coating in view of the improvement of the properties.

In order to obtain good far-infrared radiating properties, it is preferable that at least one oxide of Ti, Cr, Al, Ni, Si and B is then formed at a thickness of about 0.1-5 μm as an outermost layer using the HCD method or the steel sheet is annealed in an oxidizing atmosphere at 500-1200°C to form an oxide coating.

The coating treatment using the HCD method may be carried out by the usual batch type apparatus. Apart from this, a method of successively coating metal and/or semimetal onto the steel sheet surface, and then forming nitride, carbide and oxide layer thereon by the continuous coating equipment (Air-to-Air apparatus) may also be used.

Particularly, when the steel sheet is used as a far-infrared radiation heating element, it is favorable to use a high melting substance such as Cr, Ni or the like as a metal and/or semimetal coating formed by wet plating method.

In the invention, it is important that the metal and/or semimetal coating is formed as an undercoat layer prior to the formation of the ceramic coating onto the steel sheet surface, whereby a considerable improvement in the corrosion resistance and adhesion properties is achieved.

According to the invention, the passage through which the evaporated vapour moves is surrounded by the focusing coil, whereby the inside of the passage containing evaporated vapour produces a good plasma state and reduces the amount of stray vapour; consequently deposition onto the substrate can be effectively conducted. Furthermore, since the plasma is locked inside the passage and surrounded by the focusing coil, there is no wasteful discharge in the ion plating apparatus and the bias voltage can stably be applied to the substrate. The adhesion properties of the ceramic coating are improved and the coating also becomes dense thus improving the corrosion resistance and smoothness.

From the results of the above experiments, it is clear that the metal and/or semimetal coating is formed as a first layer onto the steel sheet surface by the HCD method according to the invention, and then the ceramic coating is formed thereon, whereby coatings which are entirely different from the coatings produced by other ion plating methods and having good adhesion properties, smoothness and corrosion resistance are obtained.

Moreover, the above effects are equalled or bettered by previously subjecting the steel sheet surface to wet plating and then subsequent oxidation treatment.

In an adaptation of the HCD method according to the invention, HCD guns are arranged side by side over a widthwise direction of the steel sheet to ensure the evaporation amount and uniformity, which can be applied to coils having a width of not less than 500 mm. Particularly, in the invention, it is important to effectively adhere the evaporated atoms to the substrate when the evaporated vapour is ionized by the HCD gun, and therefore, it is essential that the focusing coil extends from the crucible to the vicinity of the substrate so a good plasma state is formed inside the focusing coil. Moreover, the distance from the upper end of the focusing coil to the substrate is preferably about 50-150 mm. In this case, it is important to restrict the supply of power to the focusing coil to within the range shown in Fig. 3.

In order to ensure the adhesion properties, corrosion resistance and uniformity of the metal and/or semimetal coating and also the ceramic coating formed on the substrate or the wet plated substrate, the steel sheet is subjected to preliminary heating at a temperature of 100-600°C prior to the formation of the coating, or a voltage of 10-200 V is applied to the steel sheet during coating, or both treatments are conducted.

Moreover, the preliminary heating before coating is usually carried out by an electron beam, or may be conducted using infrared rays or usual resistance heating.

Further, when the voltage of 10-200 V is applied to the steel sheet, it is more advantageous that a high voltage of 50-200 V is used for the first half stage of the coating and a low voltage of 10-50 V is used for the last half stage of the coating with the intention of improving adhesion properties of the coating.

It is favorable that the steel sheet surface is completely degreased or, if necessary, the steel sheet surface is rendered into a mirror state by mechanical polishing or chemical or electrolytic polishing prior to the ion plating treatment. The metal and/or semimetal coating is formed on such a mirror finished surface.

According to the invention, it is possible to form a coating having excellent adhesion properties without conducting the usual bombardment treatment. In this case, after a passivating coating is formed by electrolytic treatment with nitric acid, the metal and/or semimetal coating may be formed.

The metal and/or semimetal may be; Ti, Zr, Hf, V, Nb, Ta, Cr, Mo, W, Mn, Co, Cu, Zn, Al, B and Si.

In this case, the coating thickness is preferably about 0.1-5 $\mu$m.

Then, the ceramic coating is formed on the metal and/or semimetal coating.

The ceramic coating is preferably at least one of the nitrides, carbides and carbonitrides of Ti, Zr, Hf, V, Nb, Ta, Cr, Mo, W, Mn, Co, Ni, Al, B and Si, and oxides of Al, Zn, Mn, Mg, Ti, Cr, B, Ni and Si. In this case, the coating thickness is preferably about 0.1-5 $\mu$m.

Although the case of forming two layer coatings consisting of a metal and/or semimetal coating as a first layer and a ceramic coating as a second layer has been mainly described, the invention is not intended to be limited to such a case, and a further ceramic coating may be formed on the above two layers irrespective of the presence or absence of a metal and/or semimetal coating. That is, a ceramic coating may be formed as a third layer, or a metal and/or semimetal coating may be formed as a third layer and a ceramic coating may be formed as a fourth layer, or further the formation of such coatings may be repeated. In brief, in the invention, the metal and/or semimetal coating is formed as an innermost layer and the ceramic coating is formed as an outermost layer.

Moreover, coated steel sheets obtained according to the invention can be used as a far-infrared radiation heating element. In this case, it is preferable that the ceramic coating of oxide is formed as an outermost layer or that the annealing is carried out in an oxidizing atmosphere of 500-1200°C after the formation of the ceramic coating.

In the deposition of metal and/or semimetal and ceramic coatings using the HCD method, a continuous vacuum line apparatus is usually used, but a batch type evaporation apparatus of a large capacity may be used.

In the invention, low carbon cold rolled steel sheets or stainless steel sheets capable of being formed in a wide area, and being relatively cheap, are advantageously used as the substrate.

## BRIEF DESCRIPTION OF THE DRAWINGS

Fig. 1 is a schematic view of a batch type ion plating apparatus applied to the invention;

Fig. 2 is a schematic view of the conventional ion plating apparatus;

Fig. 3 is a graph showing a relationship between the power of the HCD beam and the power of the focusing coil upon the quality of the ceramic coating; and

Fig. 4 is a graph showing the wavelength dependency of radioactivity at a surface temperature of 600°C.

## BEST MODE OF CARRYING OUT THE INVENTION

### Example 1

A hot rolled sheet of stainless steel containing C: 0.038%, Si: 0.12%, Mn: 1.0%, Cr: 17.5% and Mo: 1.4% (2.2 mm thickness) was cold rolled to a thickness of 0.3 mm and subjected to an annealing treatment, from which a specimen of 500 mm x 500 mm was cut out as a substrate. After the surface of the substrate was degreased, a coating selected from various metals and semimetals was formed on the surface at a thickness of 0.5 $\mu$m by an ion plating treatment using the apparatus shown in Fig. 1, and then various ceramic coatings were formed thereon at a total thickness of 1.0 $\mu$m. Then, third and fourth layers were formed on a part of the product. The adhesion properties, smoothness, corrosion resistance and densifying degree of the thus obtained products were measured. The results are shown in Table 4.

Moreover, the conditions of the ion plating treatment were acceleration current: 1000 A, acceleration voltage: 70 V, vacuum: 7x10$^{-4}$ Torr (9.3x10$^{-2}$Pa), voltage and current of focusing coil: 10 V, 800 A, bias voltage: 80 V and preliminarily heating temperature: 500°C.

## Table 4(a)

| No. | Remarks | Kind of coatings | | | | Adhesion propertty | Smoothness | Corrosion resistance | Porosity |
|---|---|---|---|---|---|---|---|---|---|
| | | first layer | second layer | third layer | fourth layer | 360° bending property *1 | surface property *2 | spraying test with saline solution *3 | ferroxyl test *4 |
| (1) | nitrides | Ti | ZrN | | | ○ | ○ | ○ | ○ |
| (2) | | Ti | HfN | | | ○ | ○ | ○ | ○ |
| (3) | | Ti | VN | | | ○ | ○ | ○ | ○ |
| (4) | | Ti | NbN | | | ○ | ○ | ○ | ○ |
| (5) | | Cr | TaN | | | ○ | ○ | ○ | ○ |
| (6) | | Cr | CrN | | | ○ | ○ | ○ | ○ |
| (7) | | Cr | MoN | CrN | | ○ | ○ | ○ | ○ |
| (8) | | Ni | NiN | TiN | | ○ | ○ | ○ | ○ |
| (9) | | Ni | AlN | Ni | AlN | ○ | ○ | ○ | ○ |
| (10) | | (Ti+Al) | $Si_3N_4$ | | | ○ | ○ | ○ | ○ |
| (11) | | (Ti+Al) | BN | | | ○ | ○ | ○ | ○ |
| (12) | carbides | Ti | TiC | | | ○ | ○ | ○ | ○ |
| (13) | | Ti | HfC | | | ○ | ○ | ○ | ○ |
| (14) | | Ti | VC | | | ○ | ○ | ○ | ○ |
| (15) | | Cr | NbC | | | ○ | ○ | ○ | ○ |
| (16) | | Cr | MoC | | | ○ | ○ | ○ | ○ |
| (17) | | V | SiC | TiC | | ○ | ○ | ○ | ○ |
| (18) | | Zr | BC | Ti | TiC | ○ | ○ | ○ | ○ |

EP 0 365 687 B1

## Table 4(b)

| No. | Remarks | Kind of coatings | | | | Adhesion propertty | Smoothness | Corrosion resistance | Porosity |
|---|---|---|---|---|---|---|---|---|---|
| | | first layer | second layer | third layer | fourth layer | 360° bending property *1 | surface property *2 | spraying test with saline solution *3 | ferroxyl test *4 |
| (19) | carbonitrides | Ti | Ti(CN) | | | ○ | ○ | ○ | ○ |
| (20) | | Cr | Cr(CN) | | | ○ | ○ | ○ | ○ |
| (21) | | V | $TiO_2$ | | | ○ | ○ | ○ | ○ |
| (22) | | Mn | $Al_2O_3$ | | | ○ | ○ | ○ | ○ |
| (23) | oxides | Cu | $SiO_2$ | | | ○ | ○ | ○ | ○ |
| (24) | | Ni | ZnO | | | ○ | ○ | ○ | ○ |
| (25) | | Co | MgO | $Al_2O_3$ | | ○ | ○ | ○ | ○ |
| (26) | | B | MnO | Ni | $TiO_2$ | ○ | ○ | ○ | ○ |

*1 ... ×: full peeling, △: some peeling, ○: no peeling

*2 ... ×: Ra>0.4 μm, ○: Ra≦0.4μm

*3 ... △: some corrosion, ○: no corrosion
(35% saline solution, 35°C, spraying for 4 hours - drying for 1 hour × 6 cycles)

*4 ... ferroxyl test (pore number per 1 $cm^2$)
×: many (more than 10), △: small (9-2), ○: very few (1 or less)

Example 2

A cold rolled sheet of a low carbon steel containing C: 0.044%, Si: 0.01%, Mn: 0.33%, P: 0.009% and S: 0.011% (a hot rolled sheet of 2.2 mm in thickness was cold rolled to a thickness of 0.7 mm) was

EP 0 365 687 B1

15

subjected to recrystallization annealing at 680°C for 10 hours. Thereafter, the surface of the steel sheet was polished to a center-line average roughness Ra of 0.2 $\mu$m by electrolytic polishing, onto which were formed a metal and/or semimetal coating (0.7 $\mu$m thickness) and a ceramic coating (0.7-0.8 $\mu$m thickness), each being made from a substance shown in Table 5, using the apparatus shown in Fig. 1 under the following HCD conditions: acceleration voltage: 80 V, acceleration current: 1000 A, vacuum degree: $8\times10^{-4}$ Torr ($1.07\times10^{-1}$Pa), focusing coil: 7 V, 600 A, bias voltage: 70 V and preliminarily heating temperature: 450°C.

Moreover, as to numerals (1), (5), (9), (13), (16) and (20) in Table 5, a thin Ni coating of 0.5 $\mu$m in thickness was formed on the steel sheet surface by wet plating prior to the dry plating.

The adhesion properties, smoothness, corrosion resistance and densifying degree of the obtained products were measured to obtain results as shown in Table 5.

Table 5(a)

| No. | Kind of ceramic compound | Presence or absence of wet plating | Coatings | | Adhesion propertty 180° bending at 20 mm (room temperature) △ some peeling ○ no peeling | Smoothness observation by scanning electron microscope (room temperature) △ some unevenness ○ no unevenness | Corrosion resistance spraying test with saline solution (*) △ some corrosion ○ no corrosion | Porosity ferroxyl test (**) |
|---|---|---|---|---|---|---|---|---|
| | | | first layer | second layer | | | | |
| (1) | nitrides | presence | Al+Cr+Ti | TiN-MnN | ○ | ○ | ○ | ○ |
| (2) | | absence | Cr | TiN-CrN-NiN | ○ | ○ | △ | ○ |
| (3) | | absence | Ti+Al | Ti(CN)-AlN-Si$_3$N$_4$ | ○ | △ | ○ | ○ |
| (4) | | absence | Cr+Al | HfN-NiN-BN-Si$_3$N$_4$ | △ | ○ | △ | ○ |
| (5) | carbides | presence | Ti | CrC-VC | ○ | ○ | ○ | ○ |
| (6) | | absence | Cr | TiC-VC | ○ | ○ | ○ | ○ |
| (7) | | absence | Ti | SiC-TiC-MnC | △ | ○ | △ | ○ |
| (8) | | absence | Cr | VC-CoC-NiC-AlC | △ | ○ | △ | ○ |
| (9) | oxides | presence | Ti | Al$_2$O$_3$-SiO$_2$ | △ | ○ | ○ | ○ |
| (10) | | absence | Cr | MgO-Al$_2$O$_3$ | ○ | ○ | ○ | ○ |
| (11) | | absence | Ti+Si | SiO$_2$-Al$_2$O$_3$-ZnO | △ | △ | △ | ○ |
| (12) | | absence | Cr+B | ZnO-Al$_2$O$_3$-MnO-TiO$_2$ | △ | △ | △ | ○ |

Table 5(b)

| No. | Kind of ceramic compound | Presence or absence of wet plating | Coatings first layer | Coatings second layer | Adhesion propertty 180° bending at 20 mm (room temperature) △ some peeling ○ no peeling | Smoothness observation by scanning electron microscope (room temperature) △ some unevenness ○ no unevenness | Corrosion resistance spraying test with saline solution (*) △ some corrosion ○ no corrosion | Porosity ferroxyl test (**) |
|---|---|---|---|---|---|---|---|---|
| (13) | nitrides and carbides | presence | Zr | Ti(CN)-VC | ○ | ○ | ○ | ○ |
| (14) | | absence | V | TiC-ZN-WN | △ | ○ | △ | ○ |
| (15) | | absence | Mn+Cr | TiN-VC-CrN-CrC | ○ | ○ | ○ | ○ |
| (16) | nitrides and oxides or carbides and oxides | presence | Ti | TiN-Al₂O₃ | ○ | ○ | ○ | ○ |
| (17) | | absence | Ti | TiN-Al₂O₃-VN | △ | △ | △ | ○ |
| (18) | | absence | Cr | TiC-SiO₂ | ○ | △ | △ | ○ |
| (19) | | absence | Cr | VC-SiO₂-ZrC | △ | ○ | ○ | ○ |
| (20) | nitrides, carbides and oxides | presence | Ti+Cr | TiN-Al₂O₃-VC | △ | ○ | ○ | ○ |
| (21) | | absence | Al+Cr | VN-SiO₂-VC-MgO | △ | △ | △ | ○ |
| (22) | | absence | Al+Cr+Ti | VC-SiO₂-Al₂O₃-TiN | ○ | △ | △ | ○ |

(*) spraying test with saline solution: 3.5% saline solution, spraying for 4 hours·drying for 1 hour × 3 cycles

(**) ferroxyl test (pore number per 1 cm²) × many (10 or more) △ small (9-2) ○ very few (1 or less)

## Example 3

A hot rolled sheet (2.3 mm thickness) of stainless steel containing C: 0.04%, Mn: 1.2%, Si: 0.08%, Cr: 17.2% and Ni: 8.9% was finished to a thickness of 0.25 mm through cold rolling and heat treatment.

Thereafter, the steel sheet surface was degreased and Cr, Ni and Ti were coated onto the steel sheet surface at respective thickness of 0.5 $\mu$m by HCD method.

Then, coatings of various nitrides and/or carbides were formed at a thickness of 1.5-3.0 $\mu$m. Thereafter, a part of the samples was subjected to coating treatment with various oxides (1.5 $\mu$m thickness) or to annealing treatment in an oxidizing atmosphere of 800°C.

The adhesion properties, peeling properties after rapid heating·rapid cooling and radiation properties (radioactivity at surface temperature of 650°C and wavelength of 7 $\mu$m) of the thus obtained products were measured to obtain the results shown in Table 6.

Table 6

| No. | First layer | Second layer (thickness) | Third layer (thickness) | Oxidation treatment | Adhesion property *1 | Peeling property *2 | Radiation property *3 |
|---|---|---|---|---|---|---|---|
| 1 | Cr | TiN (1.5 µm) | $SiO_2$ (1.5 µm) | — | ○ | ○ | 0.8 |
| 2 | Cr | AlN (") | $TiO_2$ (") | — | ○ | ○ | 0.8 |
| 3 | Cr | $Si_3N_4$ (") | $CrO_2$ (") | — | ○ | △ | 0.7 |
| 4 | Cr | TiC+BN (") | $TiO_2+SiO_2$ (") | — | ○ | ○ | 0.8 |
| 5 | Ni | $CrC+Si_3N_4$ (") | $SiO_2+NiO$ (") | — | △ | ○ | 0.9 |
| 6 | Ni | TiC (") | $Al_2O_3$ (") | — | ○ | △ | 0.8 |
| 7 | Ni | $Si_3N_4+TiC$ (") | $CrO_3$ (") | — | ○ | ○ | 0.8 |
| 8 | Ni | NiC+TiC (") | $NiO+Al_2O_3$ (") | — | ○ | ○ | 0.8 |
| 9 | Ti | CrC+AlN (") | $Al_2O_3$ (") | — | ○ | ○ | 0.8 |
| 10 | Ti | $Si_3N_4$+BN+AlN (") | $NiO+Al_2O_3+NiO$ (") | — | ○ | ○ | 0.9 |
| 11 | Ti | NiC+SiC+AlN (") | $SiO_2+Al_2O_3+TiO_2$ (") | — | ○ | △ | 0.7 |
| 12 | Ti | TiN+Ti(C,N)+BN+AlN (") | $TiO_2+CrO_2$ (") | — | △ | ○ | 0.9 |
| 13 | Cr | TiN (3.0 µm) | — | oxidizing atmosphere of 800°C | ○ | ○ | 0.8 |
| 14 | Cr | Ti(C,N) (") | — | " | ○ | △ | 0.8 |
| 15 | Cr | TiN+CrN (") | — | " | ○ | ○ | 0.8 |
| 16 | Ni | AlN+TiC (") | — | " | ○ | ○ | 0.8 |
| 17 | Ni | CrC (") | — | " | ○ | ○ | 0.7 |
| 18 | Ni | BN+AlN+TiC (") | — | oxidizing atmosphere of 1000°C | △ | ○ | 0.7 |
| 19 | Ti | AlN+CrN+TiN (") | — | " | ○ | ○ | 0.8 |
| 20 | Ti | NiC+AlN+SiC (") | — | " | △ | ○ | 0.9 |
| 21 | Ti | BN+AlN+TiC+CrC (") | — | " | ○ | ○ | 0.8 |

*1 90° bending property (repeat 4 times) ○: no peeling △: some peeling ×: peeling
*2 Peeling properties at rapid heating·rapid cooling ○: no peeling △: some peeling ×: peeling
*3 radioactivity at sample temperature (600°C) and wavelength of 7 µm

INDUSTRIAL APPLICABILITY

According to the invention, densely coated steel sheets can be obtained which have excellent adhesion properties, smoothness, uniformity and corrosion resistance. Consequently these steel sheets can be used in applications requiring various surface properties including wear resistance and corrosion resistance.

EP 0 365 687 B1

**Claims**

1. A steel sheet with a dense ceramic coating, the sheet having improved adhesion properties, smoothness and corrosion resistance, comprising an undercoat formed on a surface of a low carbon steel sheet or a stainless steel sheet and made from at least one metal and/or semimetal, and at least one layer of ceramic coating formed on said undercoat ; the ceramic coating having a surface roughness value Ra of not more than 0.4 $\mu$m and a pore number per 1 cm$^2$ of not more than 1.

2. A steel sheet as claimed in claim 1, wherein the metal and/or semimetal coating is existent between ceramic coatings.

3. A steel sheet as claimed in claim 1 or 2, wherein the ceramic coating is made from at least one of the following: nitrides, carbides or carbonitrides of Ti, Zr, Hf, V, Nb, Ta, Cr, Mo, W, Mn, Co, Ni, Al, B and Si, and oxides of Al, Zn, Mn, Mg, Ti, Cr, B, Ni and Si.

4. A steel sheet as claimed in claims 1, 2 or 3 wherein the metal and/or semimetal coating is formed from at least one of: Ti, Zr, Hf, V, Nb, Ta, Cr, Mo, W, Mn, Co, Cu, Zn, Al, B and Si.

5. A method of producing steel sheets with a dense ceramic coating, the ceramic coating having improved adhesion properties, smoothness and corrosion resistance by forming a ceramic coating onto the surface of a low carbon steel sheet or stainless steel sheet using an HCD ion plating treatment, which method comprises the steps of:
   a) forming a metal and/or semimetal coating including at least one metal and/or semimetal as a first layer onto the surface of the steel sheet, and
   b) forming a ceramic coating as a second layer on the metal and/or semimetal coating,
   using the inside of a focusing coil as the passage for evaporated vapour, wherein the power of HCD beam satisfies the relationship:

   $$30 \leq H \leq 160$$

   and the power of focusing coil satisfies the relationship:

   $$0.2 + 0.03H \leq F \leq 5.5 + 0.075H$$

   where H is the power (kW) of the HCD beam and F is the power (kW) of the focusing coil.

6. A method of producing steel sheets as claimed in claim 5, wherein the surface of the steel sheet is subjected to a polishing treatment so that the roughness of the surface has a value of Ra$\leq$0.4 $\mu$m prior to formation of the metal and/or semimetal coating as a first layer.

7. A method of producing steel sheets as claimed in claims 5 or 6, wherein the steel sheet is heated to 100-600°C prior to formation of the metal and/or semimetal coating as a first layer.

8. A method of producing steel sheets as claimed in claims 5, 6 or 7, wherein the surface of the steel sheet is subjected to Cr or Ni plating by wet plating prior to the formation of the metal and/or semimetal coating as a first layer.

9. A method or producing steel sheets as claimed in claims 5, 6, 7 or 8, wherein the formation of a second ceramic coating is effected on top of the ceramic coating.

10. A method of producing steel sheets as claimed in any of claims 5 to 9, wherein an annealing treatment is carried out in an oxidizing atmosphere of 500-1200°C after the formation of the ceramic coating as a final layer.

11. A method of producing steel sheets as claimed in any of claims 5 to 10, wherein the ceramic coating is made from at least one of the nitrides, carbides or carbonitrides of Ti, Zr, Hf, V, Nb, Ta, Cr, Mo, W, Mn, Co, Ni, Al, B and Si, and the oxides of Al, Zn, Mn, Mg, Ti, Cr, B, Ni and Si.

21

**12.** A method of producing steel sheets as claimed in any of claims 5 to 11 wherein the metal and/or semimetal coating is formed from at least one of: Ti, Zr, Hf, V, Nb, Ta, Cr, Mo, W, Mn, Co, Cu, Zn, Al, B and Si.

**Patentansprüche**

**1.** Stahlblech mit einer dichten Keramikbeschichtung, wobei das Blech bessere Hafteigenschaften, Glätte und Korrosionsbeständigkeit hat, enthaltend eine Grundbeschichtung, die auf der Oberfläche eines Blechs aus kohlenstoffarmem Stahl oder rostfreiem Stahl ausgebildet und aus mindestens einem Metall und/oder Halbmetall hergestellt wurde, und mindestens eine Schicht einer Keramikbeschichtung, die auf der Grundbeschichtung ausgebildet wurde, wobei die Keramikbeschichtung einen Oberflächenrauhwert Ra von nicht mehr als 0,4 $\mu$m und eine Porenanzahl pro 1 cm$^2$ von nicht mehr als 1 hat.

**2.** Stahlblech nach Anspruch 1, wobei die Metall- und/oder Halbmetallbeschichtung zwischen Keramikbeschichtungen vorliegt.

**3.** Stahlblech nach Anspruch 1 oder 2, wobei die Keramikbeschichtung aus mindestens einem der folgenden Nitride, Carbide oder Carbonitride von Ti, Zr, Hf, V, Nb, Ta, Cr, Mo, W, Mn, Co, Ni, Al, B und Si und Oxide von Al, Zn, Mn, Mg, Ti, Cr, B, Ni und Si besteht.

**4.** Stahlblech nach Anspruch 1, 2 oder 3, wobei die Metall- und/oder Halbmetallbeschichtung aus mindestens einem der Elemente Ti, Zr, Hf, V, Nb, Ta, Cr, Mo, W, Mn, Co, Cu, Zn, Al, B und Si gebildet wurde.

**5.** Verfahren zur Herstellung von Stahlblechen mit einer dichten Keramikbeschichtung, wobei die Keramikbeschichtung bessere Hafteigenschaften, Glätte und Korrosionsbeständigkeit besitzt, durch Ausbilden einer Keramikbeschichtung auf der Oberfläche eines Blechs aus kohlenstoffarmem oder rostfreiem Stahl mit einer HCD-Ionenplattierungsbehandlung, wobei das Verfahren die Schritte umfaßt:
a) Ausbilden einer Metall- und/oder Halbmetallbeschichtung, die mindestens ein Metall und/oder Halbmetall enthält, als erste Schicht auf der Oberfläche des Stahlblechs und
b) Ausbilden einer Keramikbeschichtung als zweite Schicht auf der Metall- und/oder Halbmetallbeschichtung,
unter Verwendung der Innenseite einer Fokussierspule als Durchgang für den erzeugten Dampf, wobei die Leistung des HCD-Strahls die Beziehung erfüllt:

$$30 \leq H \leq 160$$

und die Leistung der Fokussierspule die Beziehung erfüllt:

$$0,2 + 0,03H \leq F \leq 5,5 + 0,075H$$

worin H die Leistung (kW) des HCD-Strahls und F die Leistung (kW) der Fokussierspule sind.

**6.** Verfahren zur Herstellung von Stahlblechen nach Anspruch 5, wobei die Oberfläche des Stahlblechs zunächst so geschliffen wird, daß der Oberflächenrauhwert Ra $\leq$ 0,4 $\mu$m beträgt, und dann als erste Schicht die Metall- und/oder Halbmetallbeschichtung ausbildet wird.

**7.** Verfahren zur Herstellung von Stahlblechen nach Anspruch 5 oder 6, wobei das Stahlblech zunächst auf 100 bis 600 °C erwärmt wird und dann als erste Schicht die Metall- und/oder Halbmetallbeschichtung ausgebildet wird.

**8.** Verfahren zur Herstellung von Stahlblechen nach Anspruch 5, 6 oder 7, wobei die Oberfläche des Stahlblechs zunächst mit Cr oder Ni naßplattiert wird und dann als erste Schicht eine Metall- und/oder Halbmetallbeschichtung ausgebildet wird.

**9.** Verfahren zur Herstellung von Stahlblechen nach Anspruch 5, 6, 7 oder 8, wobei auf der Oberseite der Keramikbeschichtung eine zweite Keramikbeschichtung hergestellt wird.

**10.** Verfahren zur Herstellung von Stahlblechen nach einem der Ansprüche 5 bis 9, wobei nach der Ausbildung der Keramikbeschichtung als letzte Schicht eine Temperbehandlung in einer oxidierenden Atmosphäre bei 500 bis 1200°C erfolgt.

**11.** Verfahren zur Herstellung von Stahlblechen nach einem der Ansprüche 5 bis 10, wobei die Keramikbeschichtung aus mindestens einem Nitrid, Carbid oder Carbonitrid von Ti, Zr, Hf, V, Nb, Ta, Cr, Mo, W, Mn, Co, Ni, Al, B und Si und Oxid von Al, Zn, Mn, Mg, Ti, Cr, B, Ni und Si besteht.

**12.** Verfahren zur Herstellung von Stahlblechen nach einem der Ansprüche 5 bis 11, wobei die Metall- und/oder Halbmetallbeschichtung aus mindestens einem der Elemente Ti, Zr, Hf, V, Nb, Ta, Cr, Mo, W, Mn, Co, Cu, Zn, Al, B und Si besteht.

**Revendications**

**1.** Tôle d'acier avec un revêtement céramique dense, la tôle ayant des propriétés d'adhérence accrues, un aspect lisse et une résistance à la corrosion, comportant une sous-couche formée sur une surface d'une tôle d'acier à teneur basse en carbone ou tôle d'acier inoxydable et faîte d'au moins un métal et/ou semi-métal, et d'au moins une couche de revêtement céramique formé sur ladite sous-couche ; le revêtement céramique ayant une valeur de rugosité de surface Ra non supérieur à 0.4 $\mu$m et un nombre de pores par cm$^2$ non supérieur à 1.

**2.** Tôle d'acier selon revendication 1, dans laquelle le revêtement métallique et/ou semi-métallique existe entre des revêtements céramiques.

**3.** Tôle d'acier selon la revendication 1 ou 2, dans laquelle le revêtement céramique est fait d'au moins un des produits suivants : nitrures, carbures ou carbonitrures de Ti, Zr, Hf, V, Nb, Ta, Cr, Mo, W, Mn, Co, Ni, Al, B et Si, et oxydes de Al, Zn, Mn, Mg, Ti, Cr, B, Ni et Si.

**4.** Tôle d'acier selon les revendications 1, 2 ou 3 dans laquelle le revêtement métallique et/ou semi-métallique est formé d'au moins un des produits suivants : Ti, Zr, Hf, V, Nb, Ta, Cr, Mo, W, Mn, Co, Cu, Zn, Al, B et Si.

**5.** Procédé de production de tôles d'acier à revêtement céramique dense, le revêtement céramique ayant des propriétés d'adhérence accrues, un aspect lisse et une résistance à la corrosion, par formation d'un revêtement céramique sur la surface d'une tôle d'acier à basse teneur en carbone ou d'une tôle d'acier inoxydable, utilisant un traitement de plaquage ionique HCD (décharge par cathode creuse), ce procédé comportant les étapes de :
a) formation d'un revêtement métallique et/ou semi-métallique comportant au moins un métal et/ou semi-métal comme première couche sur la surface de la tôle d'acier, et
b) formation d'un revêtement céramique comme seconde couche sur le revêtement métallique et/ou semi-métallique, utilisant l'intérieur d'une bobine de focalisation comme passage pour la vapeur évaporée, dans lequel la puissance du rayon HCD (décharge par cathode creuse) satisfait au rapport :

$$30 \leq H \leq 160$$

et la puissance de la bobine de focalisation satisfait au rapport :

$$0.2 + 0.03H \leq F \leq 5.5 + 0.075H$$

où H est la puissance (kW) du rayon HCD (décharge par cathode creuse) et F = puissance (kW) de la bobine de focalisation.

**6.** Procédé de production de tôles d'acier selon la revendication 5, dans lequel la surface d'une tôle d'acier est soumise à traitement de polissage afin que la rugosité de la surface ait une valeur de Ra≦0.4 $\mu$m avant formation du revêtement métallique et/ou semi-métallique comme première couche.

**7.** Procédé de production de tôles d'acier selon les revendications 5 ou 6, dans lequel la tôle d'acier est chauffée à 100-600°C avant la formation du revêtement métallique et/ou semi-métallique comme première couche.

**8.** Procédé de production de tôles d'acier selon les revendications 5, 6 ou 7, dans lequel la surface de la tôle d'acier est soumise à un plaquage Ni ou Cr par plaquage humide avant la formation du revêtement métallique et/ou semi-métallique comme première couche.

**9.** Procédé de production de tôles d'acier selon les revendications 5, 6, 7 ou 8, dans lequel la formation d'un second revêtement céramique est opérée sur le revêtement céramique.

**10.** Procédé de production de tôles d'acier selon l'une quelconque des revendications 5 à 9, dans lequel un traitement de recuit est effectué dans une atmosphère oxydante de 500-1200°C après formation du revêtement céramique comme couche finale.

**11.** Procédé de production de tôles d'acier selon l'une quelconque des revendications 5 à 10, dans lequel le revêtement céramique est fait à partir d'au moins un des nitrures, carbures ou carbonitrures de Ti, Zr, Hf, V, Nb, Ta, Cr, Mo, W, Mn, Co, Ni, Al, B et Si, et des oxydes de Al, Zn, Mn, Mg, Ti, Cr, B, Ni et Si.

**12.** Procédé de production de tôles d'acier selon l'une quelconque des revendications 5 à 11 dans lequel le revêtement métallique et/ou semi-métallique est formé d'au moins un des produits suivants : Ti, Zr, Hf, V, Nb, Ta, Cr, Mo, W, Mn, Co, Cu, Zn Al, B et Si.

# FIG.1

EP 0 365 687 B1

# FIG_2

26

30

27

N₂ Gas

31

29

28

# FIG. 3

# FIG_4